## Europäisches Patentamt

## European Patent Office

## Office européen des brevets

(11) Publication number: **0 131 031**
**B1**

## EUROPEAN PATENT SPECIFICATION

(45) Date of publication of patent specification: **17.10.90**

(21) Application number: **84900454.4**

(22) Date of filing: **19.12.83**

(86) International application number:
**PCT/US83/02007**

(87) International publication number:
**WO 84/02826 19.07.84 Gazette 84/17**

(51) Int. Cl.⁵: **H 05 K 3/18,** C 23 C 18/04,
C 25 D 5/56

(54) **METHOD OF TREATING THERMOPLASTIC SURFACES.**

(30) Priority: **30.12.82 US 454786**

(43) Date of publication of application:
**16.01.85 Bulletin 85/03**

(45) Publication of the grant of the patent:
**17.10.90 Bulletin 90/42**

(84) Designated Contracting States:
**BE DE FR GB**

(56) References cited:
**SU-A- 775 887**
**US-A-3 489 590**
**US-A-3 560 241**
**US-A-3 869 303**
**US-A-4 125 649**
**US-A-4 339 303**

**Electronics, Volume 55, No. 5, 10 March 1982
(New York, N.Y.), Jerry Lyman, "Thermoplastics
Take to the Boards", pages 105, 106**

(73) Proprietor: **GOULD INC.**
**10 Gould Center**
**Rolling Meadows, IL 60008 (US)**

(72) Inventor: **PUTT, Ronald, Alan**
**936 Waterford**
**Eagan, MN 55123 (US)**
Inventor: **ATTIA, Alan, I.**
**10641 Utica Circle**
**Bloomington, MN 55437 (US)**

(74) Representative: **Crawford, Andrew Birkby et al
A.A. THORNTON & CO. Northumberland House
303-306 High Holborn
London WC1V 7LE (GB)**

Courier Press, Leamington Spa, England.

## Description

This invention relates to the treatment of thermoplastic surfaces, more particularly polyphenylene sulphide, polysulphone or polyether sulphone surfaces, in order to activate them with respect to a subsequent treatment.

In the manufacture of printed circuit boards, a thin layer of electroless copper is deposited on a substrate followed by the deposition of a thicker layer of electrodeposited copper thereon. In order to provide a proper and good bond between the substrate, which conventionally is formed of nonconductive material, such as thermoplastic synthetic resin material, and the conductive copper layer, it is important to provide a surface on the substrate which is suitably reactive to nucleate with the electroless layer. Conventionally the electroless layer includes palladium and it is desirable to activate the substrate surface so as to nucleate the palladium.

It has been conventional to effect such treatment of the surface by etching or abrading the surface. The known methods of treating the substrate surface have not proven completely satisfactory in that they have tended to damage the substrate surface and to impair the dimensional stability of the substrate.

A number of thermoplastic synthetic resins have been found to be advantageously adapted for use as substrates in printed circuit boards. An excellent example of such a material is polyphenylene sulphide sold under the trademark Ryton, polysulphone sold under the trademark Udel by Union Carbide, and polyether sulphone sold under the trade name Victrex by Imperial Chemical Industries Ltd.

While polyphenylene sulphide, polysulphone and polyether sulphone are particularly advantageous materials for such printed circuit board use, it has been particularly difficult to form the desirable activated surface on them.

We have now found that polyphenylene sulphide, polysulphone and polyether sulphone surfaces can be activated, particularly with a view to the subsequent electroless plating thereof, by the use of an aqueous solution containing bromine and a chloride or bromide salt.

According to the present invention therefore, there is provided a method of treating the surface of a body formed of polyphenylene sulphide, polysulphone or polyether sulphone, which comprises treating the surface with an aqueous solution containing bromine and a chloride or bromide salt to improve the bond between the body and a subsequent electroless metal plating thereon.

The chloride or bromide salt is preferably a quaternary ammonium chloride or bromide or a Group I, II or III chloride or bromide salt.

The treatment of the surface is preferably carried out at a temperature of less than 93°C (200°F).

The surface is preferably degreased prior to the step of subjecting the surface to the aqueous solution.

The invention also comprises the provision of the further step of depositing a layer of electroless copper on the polymeric surface following the treatment of the latter with the solution. The electroless copper layer provides desirable adhesion for a subsequent plating of electrolytic copper, such as in the forming of printed circuit boards and the like.

The following examples of specific treatments are given by way of illustration only.

Samples of Ryton R-4 and BR-57 and Victrex 420P and 520P were treated in a 2M KBr solution in water containing 25 g/l of bromine at 50°C for 30 minutes followed by subjection thereof to a commercial electroless copper plating process with good results.

Broadly, Ryton has been found to be satisfactorily activated by subjection thereto to a solution of 1 to 50 grams of $Br_2$ per litre in an aqueous solution that is 1—3 molar with respect of NaCl, KCl, KBr, $CaBr_2$, $CaCl_2$, $ZnBr_2$, $ZnCl_2$, or any soluble group I, II, or III chloride or bromide salt. Liquid bromine complexes with quaternary ammonium compounds may be used to effect the desired activation with slightly less efficiency, although the necessary bromine concentration therein is substantially higher, such as up to 1000 grams per litre.

In carrying out the process, it is preferable that the substrate bodies are firstly degreased prior to subjection to the bromine-containing solution. Further, the samples are rinsed prior to the electroless plating step.

Heretofore, no known etchants were available for Ryton and as Ryton offers a number of advantages for use as a substrate for printed circuit boards, the novel activation process of the present invention offers a highly desirable improvement in the art. Both Udel and Victrex substrates required solvent pre-etching steps which adversely affected the dimensional stability of the substrate. Mechanical abrasion of the substrate surface also has led to similar problems relative to dimensional stability.

Thus, the method of the present invention for etching thermoplastics, such as Ryton, Udel and Victrex, provides an unexpected, novel activation of such materials such as for use in accepting an electroless plating of copper or nickel for subsequent deposition of a thicker layer of copper, as in the manufacture of printed circuit boards.

## Claims

1. A method of treating the surface of a body formed of polyphenylene sulphide, polysulphone or polyether sulphone, which comprises treating the surface with an aqueous solution containing bromine and a chloride or bromide salt to improve the bond between the body and a subsequent electroless metal plating thereon.

2. A method according to claim 1, in which the chloride or bromide salt is a quaternary ammonium chloride or bromide or a Group I, II or III chloride or bromide salt.

2

3. A method according to claim 1 or 2, in which the solution contains, per litre, from 1 to 50 grams of bromine per litre and from 1 to 3 moles of the chloride or bromide salt.

4. A method according to any of claims 1 to 3, in which the treatment of the surface is carried out at a temperature of less than 93°C (200°F).

5. A method according to any of claims 1 to 4, in which the surface is degreased prior to treatment with the aqueous solution.

6. A method according to any of claims 1 to 5, in which, following treatment with the aqueous solution, a layer of electroless copper is deposited on the surface.

7. A method according to any of claims 1 to 6, in which the body is a printed circuit board.

## Patentansprüche

1. Verfahren zur Behandlung der Oberfläche eines durch Polyphenylensulfid, Polysulfon oder Polyäthersulfon gebildeten Körpers, das die Behandlung der Oberfläche mit einer wässerigen Lösung umfaßt, um die Brom und ein Chlor- oder Bromsalz enthält, um die Bindung zwischen dem Körper und einer nachfolgenden stromlosen Metallplattierung darauf zu verbessern.

2. Verfahren nach Anspruch 1, bei dem das Chlor- oder Bromsalz ein quatäres Chlorammonium oder Bromammonium oder ein Chlorsalz oder Bromsalz der Gruppe I, II oder III ist.

3. Verfahren nach Anspruch 1 oder 2, bei dem die Lösung pro Liter 1 bis 50 g Brom pro Liter und 1 bis 3 Grammoleküle des Chlor- oder Bromsalzes enthält.

4. Verfahren nach einem der Ansprüche 1 bis 3, bei dem die Behandlung der Oberfläche bei einer Temperatur unter 93°C (200°F) duchgeführt wird.

5. Verfahren nach einem der Ansprüche 1 bis 4, bei dem die Oberfläche vor der Behandlung mit der wässerigen Lösung entfettet wird.

6. Verfahren nach einem der Ansprüche 1 bis 5, bei dem nach der Behandlung mit der wässerigen Lösung sich eine Schicht stromlosen Kupfers auf der Oberfläche niederschlägt.

7. Verfahren nach einem der Ansprüche 1 bis 6, bei dem der Körper eine gedruckte Leiterplatte ist.

## Revendications

1. Procédé de traitement de la surface d'un corps constitué de polysulfure de phénylène, polysulfone ou polyéthersulfone, qui consiste à traiter la surface par une solution aqueuse contenant du brome et un sel de type chlorure ou bromure pour améliorer la liaison entre le corps et un dépôt de métal chimique appliqué par la suite.

2. Procédé selon la revendication 1, dans lequel le sel de type chlorure ou bromure est un chlorure ou bromure d'ammonium quaternaire ou un chlorure ou bromure d'élément du Groupe I, II ou III.

3. Procédé selon la revendication 1 ou 2, dans lequel la solution contient, par litre, 1 à 50 grammes de brome et 1 à 3 moles du sel de type chlorure ou bromure.

4. Procédé selon l'une quelconque des revendications 1 à 3, dans lequel le traitement de la surface est effectué à une température inférieure à 93°C (200°F).

5. Procédé selon l'une quelconque des revendications 1 à 4, dans lequel la surface est dégraissée avant le traitement par la solution aqueuse.

6. Procédé selon l'une quelconque des revendications 1 à 5, dans lequel, après le traitement par la solution aqueuse, une couche de cuivre chimique est déposée sur la surface.

7. Procédé selon l'une quelconque des revendications 1 à 6, dans lequel le corps est une plaquette de circuit imprimé.